(19) **Europäisches Patentamt / European Patent Office / Office européen des brevets**

(11) **EP 2 927 968 B1**

(12) **EUROPEAN PATENT SPECIFICATION**

(45) Date of publication and mention of the grant of the patent:
**08.09.2021 Bulletin 2021/36**

(51) Int Cl.:
***H01L 31/0693*** *(2012.01)*

(21) Application number: **15000925.6**

(22) Date of filing: **30.03.2015**

(54) **HIGHLY EFFICIENT PHOTOVOLTAIC ENERGY HARVESTING DEVICE**

HOCHEFFIZIENTE PHOTOVOLTAISCHE ENERGIEGEWINNUNGSVORRICHTUNG

DISPOSITIF DE COLLECTE D'ÉNERGIE PHOTOVOLTAÏQUE TRÈS EFFICACE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.04.2014 US 201414242250**

(43) Date of publication of application:
**07.10.2015 Bulletin 2015/41**

(73) Proprietor: **Lightricity Ltd**
**Oxford OX4 4GB (GB)**

(72) Inventors:
• **Bellanger, Mathieu**
  **Oxford, OX4 4GB (GB)**
• **DAY, Stephen**
  **Oxford, OX4 4GB (GB)**
• **Kauer, Matthias**
  **Oxford, OX4 4GB (GB)**
• **Rihani, Samir**
  **Oxford, OX4 4GB (GB)**

(74) Representative: **Müller Hoffmann & Partner Patentanwälte mbB**
**St.-Martin-Strasse 58**
**81541 München (DE)**

(56) References cited:
**US-A1- 2009 250 101     US-A1- 2011 186 115**

• **P. DAI ET AL: "The investigation of GaInP solar cell grown by all-solid MBE", JOURNAL OF CRYSTAL GROWTH, vol. 378, 1 September 2013 (2013-09-01), pages 604-606, XP055206879, ISSN: 0022-0248, DOI: 10.1016/j.jcrysgro.2012.12.038**
• **J. F. GEISZ ET AL: "Enhanced external radiative efficiency for 20.8% efficient single-junction GaInP solar cells", APPLIED PHYSICS LETTERS, vol. 103, no. 4, 1 January 2013 (2013-01-01), page 041118, XP055206878, ISSN: 0003-6951, DOI: 10.1063/1.4816837**
• **None**

**Description**

**TECHNICAL FIELD**

The invention relates to energy harvesting and, more particularly, to single-junction photovoltaic cells. In addition, the invention relates to a device structure design for achieving a higher efficiency and method of making such device.

**BACKGROUND ART**

The Internet of Things (IoT) is a relatively recent concept whereby wireless autonomous sensors are used to provide functions such as short range communications, proximity sensing and tracking, condition monitoring and automated control of the surrounding environment. For example, building automation typically requires a large number of sensor nodes that can communicate wirelessly and autonomously with each other.

Primary batteries (e.g. Li coin cells) are commonly used to power such sensors, but they currently suffer from limited lifetime and environmental concern. Moreover, in large buildings where a significant number of sensor nodes is required, it is undesirable to regularly replace the batteries and therefore preferable that the power for such sensor nodes be provided by energy harvesting (EH) devices that can convert renewable mechanical, thermal or electromagnetic (light) energy into useful electricity. These EH harvesting devices may be used as a stand-alone source of energy for the sensor node or implemented in a hybrid configuration whereby the EH is used to extend the lifetime of a secondary battery.

Photovoltaic devices represent a significant fraction of these EH devices and are particularly attractive in building automation applications, since they are able to operate under indoor artificial light sources or under a combination of outdoor sunlight and indoor artificial light sources (e.g. near a window). In both cases, the available power can vary by several orders of magnitude depending on the position and orientation of the sensor relative to the incoming light, and the available power will often be much lower than under standard outdoor conditions.

Most Photovoltaic Energy Harvesting devices (PVEH) are currently based on amorphous Silicon (a-Si) or crystalline Silicon (c-Si). a-Si offers a better performance than c-Si under the artificial lighting conditions stated above. The efficiency of said a-Si PV devices is still limited to around 15% under low to moderate illumination (200-1000 lux) and drops rapidly under ultra-low light conditions (<<100 lux) . The poor ultra-low light performance is attributed to the higher impact of the dark current and shunt resistance on the open-circuit voltage and fill factor respectively under ultra-low light conditions.

Wireless sensor networks operating under indoor artificial lights can experience ultra-low light levels (<<100 lux) for extended periods of time due to partial shading from direct lighting, oblique acceptance angles for wall mounted units, or because of the specific requirements of the local environment, e.g. in cinemas, conference centres, hotels etc. These dimmed light applications cannot be successfully addressed by conventional Silicon (Si) technology. Similarly, the conventional Si PVEH cannot be designed for a wide dynamic range of illumination levels and efficient operation of amorphous PVEH is limited to low and moderate illumination (100-1000 lux).

Consequently, a heavy trade-off between the size of the Si PVEH and provided functionality is currently required. Provided functionality includes the type of measurement performed by the sensor (e.g., temperature, wind...), data processing capability, and transmission rate of measured data.

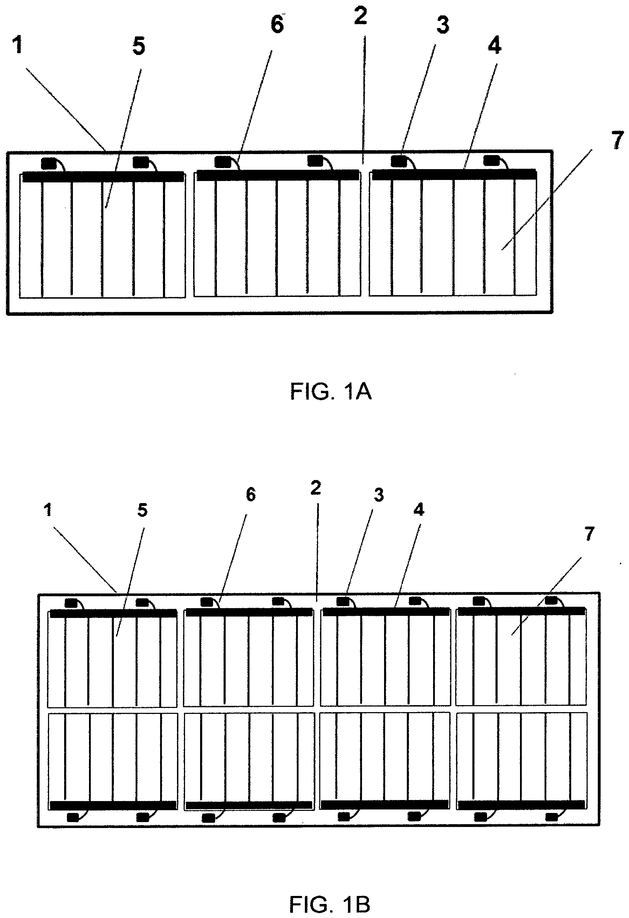

Another limitation of a-Si and c-Si PVEH devices is the small open-circuit voltage achievable with a single Si PV cell (e.g <0.65 V). That means a large number PV cells, typically 8, needs to be connected in series to achieve the 3V voltage typically required to power the sensor electronics. FIG. 1B shows a conventional 8-cell configuration for c-Si, comprising 8 PV cells **7** connected in series and mounted on an inactive PVEH area **2**. The PV cells have front external metal pads **3**, metal gridlines **5** and bus-bar electrodes **4** connected by metal leads **6.**

In addition to the limited performance, a last limitation is related to the aesthetics of the Si PVEH devices. As can be observed in FIG. 1A and FIG 1B, metal gridlines **5** typically are visible on the device. For a-Si, the cell interconnects are realised by monolithical integration and laser scribed lines are also clearly visible. This may be an issue for some high value applications where aesthetics of PVEH is to be considered.

Dye-sensitised solar cells (DSSC) and organic solar cells have been suggested as potential alternatives to Si for PVEH devices. However, these technologies suffer from stability and performance issues that will necessitate more development before they can make a sufficient impact in the PVEH field.

Another alternative has been to use high purity Gallium Arsenide (GaAs) crystal as the active PV material ["The Opto-Electronic Physics that Broke the Efficiency Limit in Solar Cells", E. Yablonovitch and al., PVSC 2012]. Although the efficiency achieved by such GaAs PVEH devices is higher than the efficiency achieved with a-Si devices, the GaAs PVEH devices are still not optimum for artificial light applications. First, most energy-efficient types of artificial lighting, such as Fluorescent (FL) and Light Emitting Diode (LED) lights, have a different spectrum compared with the standard AM1.5G solar spectrum. The band-gap of GaAs (1.4 eV) is thus optimum for outdoor solar spectrum but not for FL and LED artificial light spectra. Under FL and LED spectra, it has been reported that the optimum band-gap shifts to larger values ["Maximum Efficiencies of Indoor Photovoltaic Devices", Freunek and al., IEEE Journal of Photovoltaics, 2013]. Second, commercial GaAs PVEH devices have a contact design that is very similar to space and concentrator III-V PV devices, e.g. bus-bars and metal front gridlines, are present on the light receiving side of the devices. This contact design is not optimised for the low light level available in typical energy harvesting applications. The conventional process for making such GaAs PVEH devices is also costly and not yet competitive with the more mature a-Si technology. The presence of metal gridlines or gridlines in the middle of the cells also affects the overall aesthetics of the PVEH, in the similar way as with Si technology.

To be a competitive alternative to primary batteries, the performance of PVEH devices needs to be further improved under more realistic conditions. The PVEH devices should cover a wide dynamic range of input light levels and still deliver the required power at ultra-low light level. Finally, the PVEH devices should be economically competitive with batteries over their lifetime and aesthetically attractive when integrated into a product design.

US 2011/0186115 A1 discloses to use GaInP for a solar cell formulated to have a direct bandgap in the range between about 1.9eV to 2.2eV. The cells are thick in order to absorb the energy. The document further teaches to provide for gold grid lines on top of the solar cell.

US 2009/0250101 A1 as well discloses the use of combinations of InGaP for a photovoltaic structure.

The article by P. Dai et al: The investigation of GaInP solar cell grown by all-solid MBE", Journal of Crystal Growth 378 (1 September 2013) pages 604-606, XP055206879, ISSN: 0022-0248, http://dx.doi.org/10.1016/j.jcrysgro.2012.12.038 discloses the behaviour of GaInP solar cells including determining the intensity in dependence of photo energy and temperature.

The article by J. F. Geisz et al: "Enhanced external radiative efficiency for 20.8% efficient single-junction GaInP solar cells", Applied Physics Letters, vol. 103, no. 4, 1 January 2013 (2013-01-01), page 041118, XP055206878, ISSN: 0003-6951, DOI: 10.1063/1.4816837 as well discloses a GaInP solar cell having an efficiency of 20:8% under AM1.5G spectrum (corresponding to one Sun intensity or 1000W/m$^2$).

## SUMMARY OF INVENTION

An object of the present invention is a Photovoltaic Energy Harvesting (PVEH) device that addresses the technical problems of achieving higher efficiency over a wider range of illumination levels as compared to conventional devices, while improving the aesthetics of said PVEH device. Another object of the present invention is a method for making said PVEH device that minimises processing costs.

More specifically, the present invention is defined according to claim 1 and discloses a high band-gap crystalline PVEH spectrally matched with an ambient light source whereby the light receiving side of the PV cells is free from conventional front metal gridlines. The efficient electrical power extraction is solely provided by one or several discrete metal contact elements located at the perimeter of the PV cells.

Besides retaining the advantages of common PVEH devices, the additional advantages of the PVEH device and method in accordance with the invention include the following:

The high band-gap and crystalline form of the PV cell active material increases the open-circuit voltage achievable with a single PV cell, thereby reducing the number of PV cells in series within the PVEH device and simplifying the interconnection scheme.

The high band-gap of the crystalline active material in combination with the low area covered by the front metal elements on the PV cells reduce the dark saturation current and the current leakage or shunt through the PV junction, thereby improving the fill factor and performance of the PVEH device under ultra-low light conditions.

An aspect of the invention is a photovoltaic energy harvesting device comprising a single-junction photovoltaic cell.

## BRIEF DESCRIPTION OF DRAWINGS

FIG. 1A is a top view of a conventional PVEH device comprising 3 PV cells connected in series, and the PV cells have front metal fingers and bus-bar electrodes.

FIG. 1B is a top view of a conventional PVEH device comprising 8 PV cells connected in series, and the PV cells have front metal fingers and bus-bar electrodes.

FIG. 2A is a top view (the light receiving side) of a high efficient PVEH device according to the present invention, comprising a single PV cell with a single metal contact element placed in the middle of a longer edge of the PV cell and with an external electrical lead directly attached.

FIG. 2B is a top view (the light receiving side) of a high efficient PVEH device according to the present invention, comprising a single PV cell wherein a single metal contact element is placed in the middle of a longer edge of the PV cell and connected to an external contact pad.

FIG. 3A is a top view of a high efficient PVEH device according to the present invention, comprising a single PV cell wherein multiple front metal contact elements are placed on the longer edge of the PV cell.

FIG. 3B is a top view of a high efficient PVEH device according to the present invention, comprising a single PV cell wherein multiple front metal contact elements are placed in the middle of each edge of the PV cell.

FIG. 3C is a top view of a high efficient PVEH device according to the present invention, comprising a single PV cell wherein multiple front metal contact elements are placed at each corner of the PV cell.

FIG. 4A is a top view of a high efficient PVEH device according to the present invention, comprising a single PV cell wherein a single metal contact element covers the longer edge of the PV cell.

FIG. 4B is a top view of a high efficient PVEH device according to the present invention, comprising a single PV cell with the front metal contact elements that cover the whole perimeter of the PV cells.

FIG. 5A is a top view of a high efficient PVEH device according to the present invention, comprising 4 PV cells connected in series wherein a single metal contact element is placed in the middle of the outer longer edge of the PV cell.

FIG. 5B is a top view of a high efficient PVEH device according to the present invention, comprising 4 PV cells connected in series wherein multiple metal contact elements are placed on the same edge of the PV cell.

FIG. 5C is a top view of a high efficient PVEH device according to the present invention, comprising 4 PV cells connected in series wherein multiple metal contact elements are placed on a different edge of the PV cell.

FIG. 6A is a top view of a high efficient PVEH device according to the present invention, comprising 4 PV cells connected in series wherein a single metal contact element covers the outer longer edges of the PV cells.

FIG. 6B is a top view of a high efficient PVEH device according to the present invention, comprising 4 PV cells connected in series wherein a single metal contact element covers the outer longer edges and the outer shorter edges of the PV cells.

FIG. 7 shows the external Quantum Efficiency of a GaInP PV cell against LED and CCFL irradiance spectra.

FIG. 8 shows measurement data of a GaInP PV cell with respect of incoming light intensity (CFL spectrum).

FIG. 9 is a schematic diagram of an autonomous wireless sensor powered with a PVEH device according to the present invention.

FIG. 10 is a cross section view of the PV cell structure according to the present invention

FIG. 11 is a representation of a wall-mounted PVEH device that includes a lens for efficient collection of ambient light

FIG. 12 shows experimental IV curves under low illumination (<50 $\mu$W.cm$^{-2}$) of a GaInP PVEH device against typical a-Si and c-Si PVEH devices.

FIG. 13 shows experimental IV curves under high illumination (>2500 $\mu$W.cm$^{-2}$) of a GaInP PVEH device against typical a-Si and c-Si PVEH devices

FIG. 14 shows experimental IV curves of a GaInP PV cell under various level of CCFL illumination.

FIG. 15 shows simulated IV of a GaInP PV cell under high light level intensity (2000 lux CCFL) for various values of emitter sheet resistance.

FIG. 16 shows simulated IV of a GaInP PV cell under high light level intensity (2000 lux CCFL) for various values of specific contact resistance.

FIG. 17 shows simulated IV of a GaInP PV cell under low light level intensity (200 lux CCFL) for various values of shunt resistance.

## DESCRIPTION OF REFERENCE NUMERALS

| | |
|---|---|
| 1 | Photovoltaic energy harvester |
| 2 | Inactive PVEH area |
| 3 | External metal pad |
| 4 | Metal busbars |
| 5 | Metal gridlines |
| 6 | Metal leads |
| 7 | Photovoltaic cell |
| 8 | photovoltaic energy harvester |
| 9 | Electrical lead |
| 10 | Metal contact element |
| 11 | Photovoltaic cell |
| 12 | Inactive PVEH area |
| 13 | External metal pad |
| 14 | Metal wire |
| 15 | Elongated metal contact element |
| 16 | Light source |
| 17 | Antenna |
| 18 | Photovoltaic energy harvesting device |
| 19 | Signal processing unit |
| 20 | Signal conditioning unit |
| 21 | Power management unit |
| 22 | Sensor |
| 23 | Anti-Reflection Coatings (ARC) |
| 24 | Emitter |
| 25 | Base |
| 26 | Substrate |
| 27 | Optical lens |
| 28 | PVEH cell |
| 29 | Light source |
| 30 | Wall |

## DETAILED DESCRIPTION OF INVENTION

An object of the present invention is a Photovoltaic Energy Harvesting (PVEH) device that addresses the technical problems of achieving higher efficiency over a wider range of illumination levels as compared to conventional devices, while improving the aesthetics of said PVEH device. Another object of the present invention is a method for making said PVEH device that minimises processing costs.

More specifically, the present invention discloses a high band-gap crystalline PVEH device spectrally matched with an ambient light source whereby the light receiving side of the PV cells within the PVEH device is free from conventional metal gridlines.

As used in this disclosure, following definitions apply:

The term "PV cell" refers to the light converting component of the PVEH device. The PVEH device may comprise one or several PV cells.

The term "high band gap" refers to band-gaps above the Silicon band-gap, e.g. >1.12 eV and up to approximately 2.0 eV.

The term "spectrally-matched" refers to the high convolution product of the PVEH spectral response with the intensity spectrum of the ambient light source, e.g the spectrum of the ambient light source predominantly occupies the wavelength range shorter than that defined by the band-gap of the PV cell.

The term "fractional power loss" refers to the power loss relative to the incoming power at the maximum power point.

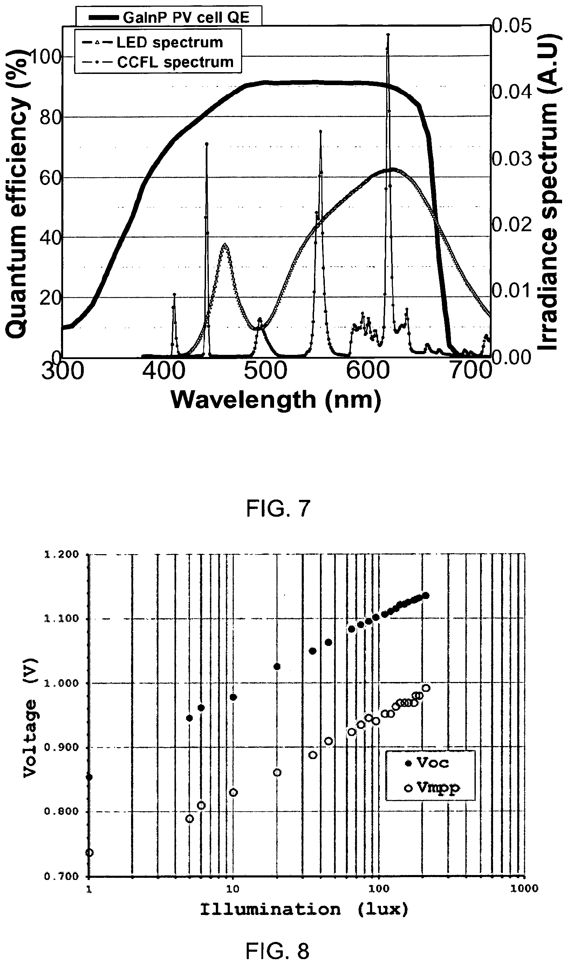

The term "ultra-low light level" refers to a light intensity level below 25 $\mu$W/cm$^2$ (eq. < 100 lux, for a typical Fluorescent Light spectrum as shown in FIG. 7).

The term "low light level" refers to a light intensity level between 25 and 100 $\mu$W/cm$^2$ (eq. -100-400 lux, for a typical Fluorescent Light spectrum as shown in FIG. 7).

The term "moderate light level" refers to a light intensity level between 100 and 250 $\mu$W/cm$^2$ (eq. ~400-1000 lux, for a typical Fluorescent Light spectrum as shown in FIG. 7).

The term "high light level" refers to a light intensity level above 250 $\mu$W/cm$^2$ (eq. >1000 lux, for a typical Fluorescent Light spectrum as shown in FIG. 7)

The performance of PV cells is generally limited by the fractional power losses due to series resistance, shunt resistance and contact shading effects.

Assuming no shunt resistance, the fill factor of the PV cell is affected by the series resistance according the following equation (Eq. 1):

$$ FF_{series} = FF_0 \cdot \left( 1 - \frac{R_{series} \cdot J_{mp}}{V_{mp}} \right) \qquad \text{(Equation 1)} $$

where $FF_0$ is the maximum fill factor of the cell without series and shunt resistance, $R_{series}$ is the area-normalised series resistance, and $J_{mp}$ and $V_{mp}$ are the current density and voltage respectively at the maximum powerpoint.

The corresponding fractional power loss due to series resistance $P_{series}$ is (Eq. 2):

$$ P_{series} = \frac{R_{series} \cdot J_{mp}}{V_{mp}} \qquad \text{(Equation 2)} $$

The fractional power losses due to series resistance can be further divided into various losses (Eq. 3):

$$ P_{series} = P_{emitter} + P_{contact(h)} + P_{contact(v)} \qquad \text{(Equation 3)} $$

where $P_{emitter}$, $P_{contact(h)}$ and $P_{contact(v)}$ are the fractional power losses due to Joule heating in the emitter, horizontal resistance along the front metal contact, and vertical contact resistance at the emitter-metal interface respectively.

In a conventional metal gridlines contact design as shown in FIG. 1A and FIG. 1B, the fractional power losses $P_{emitter-gridlines}$, $P_{contact(h)-gridlines}$ and $P_{contact(v)-gridlines}$ in each PV cell are defined by (Eq. 4, 5 and 6):

$$ P_{emitter-gridlines} = \frac{(\rho_\square \cdot S^2 \cdot J_{mp})}{12 \cdot V_{mp}} \qquad \text{(Equation 4)} $$

$$P_{contact(h)-gridlines} = \frac{(\rho_{metal}.L^2.S.J_{mp})}{3.w.h.V_{mp}} \quad \text{(Equation 5)}$$

$$P_{contact(v)-gridlines} = \frac{A_{PV}.R_{c(g)}.J_{mp}}{A_{c(g)}.V_{mp}} \quad \text{(Equation 6)}$$

where po is the sheet resistance of the emitter layer, S the spacing between adjacent metal gridlines, $\rho_{metal}$ is the resistivity of the metal, $J_{mp}$ and $V_{mp}$ the current density and voltage respectively at the maximum powerpoint.

W, L and h are respectively the width, length and height of a metal gridline.

$R_{c(g)}$ is the specific contact resistance of the front metal gridlines, $A_{PV}$ and $A_{c(g)}$ are the area of the PV cell and metal gridlines respectively.

In addition to the shunt and series resistance losses, there is a fractional power loss $P_{shading}$ due to the shading by the front metal contacts (Eq. 7):

$$P_{shading} = \frac{A_c}{A_{PV}} \quad \text{(Equation 7)}$$

where $A_{PV}$ and $A_c$ are the area of the PV cell and front metal contact respectively.

The sum $P_{se-sh}$ of the fractional power losses due to series resistance and contact shading should be minimised to optimise the performance of each PV cell under a given range of ambient light intensity $I_{ambient}$ (Eq. 8):

$$P_{se-sh} = P_{series} + P_{shading} \quad \text{(Equation 8)}$$

In a conventional metal gridlines contact design, the minimum $P_{se-sh}$ achievable after optimisation is typically 5-8% when considering the metal gridlines alone, and >15% when including the shading loss from the metal bus-bars.

In the present invention, a completely different geometry is used to minimise the sum $P_{se-sh}$ of fractional power losses under a wide dynamic range from ultra-low light, low to at least moderate light levels.

In the present invention, the efficient electrical power extraction is not provided by metal gridlines, but rather is solely provided by one or several discrete metal contact elements preferably located at the perimeter of the PV cells. The metal elements can be of any geometrical shape but preferably point contact, circular or rectangular.

In the example of a circular contact (cc), in the present invention, the shading loss $P_{shading-cc}$ due to the metal contact elements is reduced by up to 5% absolute when considering the metal gridlines alone, and up to 15% absolute when considering the shading loss from the metal bus-bars in conventional designs.

In the present invention, the fractional power losses due to series resistance $P_{emitter-cc}$, $P_{contact(h)-cc}$ and $P_{contact(v)-cc}$, for a single circular contact and square-shaped PV cell are (Eq. 9,10 and 11):

$$P_{emitter-cc} = \frac{J_{mp}.\rho_\square}{A_{PV}.V_{mp}} \int_0^{\frac{a}{2}-r_c} \frac{\{(a^2.(1-\frac{\pi}{4}) + \pi.x(a-x)\}^2}{\pi.(a-2x)} .dx$$

(Equation 9)

$$P_{contact(h)-cc} \sim 0 \qquad \text{(Equation 10)}$$

$$P_{contact(v)-cc} = \frac{A_{PV} \cdot R_{c(cc)} \cdot J_{mp}}{A_{c(cc)} \cdot V_{mp}} \qquad \text{(Equation 11)}$$

where $P_{emitter-cc}$, $P_{contact(h)-cc}$ and $P_{contact(v)-cc}$ are the fractional power losses due to Joule heating in the emitter, horizontal resistance along the front metal contact, and vertical contact resistance at the emitter-metal interface respectively, for a single circular contact.

$\rho_\square$ is the sheet resistance of the emitter layer, a is the length of the PV cell, $r_c$ is the radius of the circular contact element $R_{c(cc)}$ is the specific contact resistance of the front metal circular contact, $A_{PV}$ are the area of the square PV cell, $J_{mp}$ and $V_{mp}$ the current density and voltage respectively at the maximum powerpoint.

$P_{emitter-cc}$ can be solved using standard numerical methods.

In the present invention and according to Eq. 10, the fractional power loss due to the horizontal resistance along a single metal contact element $P_{contact(h)-cc}$ is greatly reduced compared to the conventional metal gridlines design.

According to the present invention, the fractional power losses $P_{emitter-cc}$ and $P_{contact(v)-cc}$ are increased compared to conventional metal gridlines design, albeit to a lesser extent than the fractional power losses $P_{shading-cc}$ and $P_{contact(h)-cc}$ are reduced.

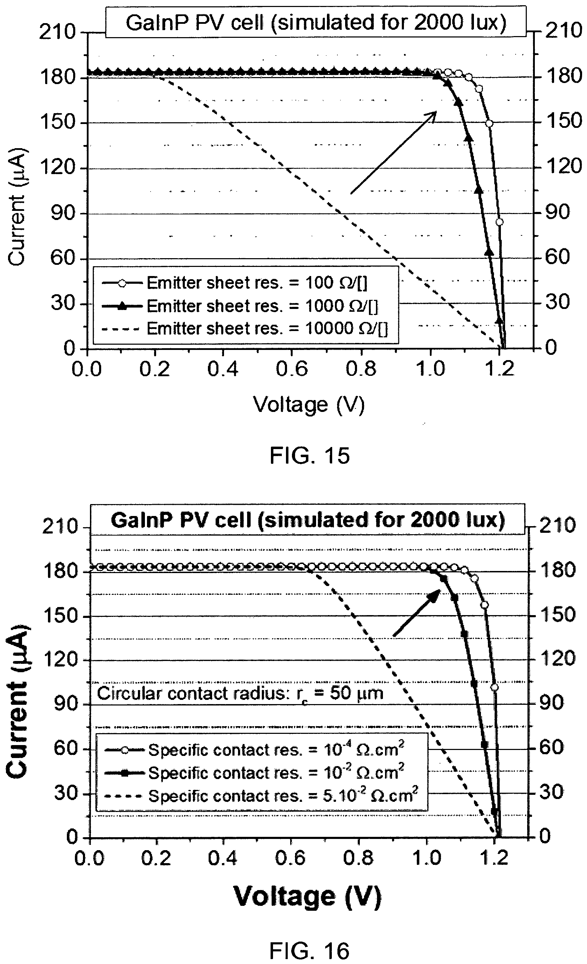

FIG. 15 shows the impact of the emitter sheet resistance on the simulated IV characteristic of a GaInP PV cell, assuming a high light level intensity of 2000 lux CCFL. The fill factor clearly decreases with increased emitter sheet resistance from 100 $\Omega/\square$ to 10000 $\Omega/\square$.

In order to minimise the fractional power loss due to Joule heating in the emitter, the emitter sheet resistance should preferably be <1000 $\Omega/\square$, and more preferably <100 $\Omega/\square$.

FIG. 16 shows the impact of the specific contact resistance (assuming single circular contact with a radius $r_c$ of 50 $\mu$m and a high light level intensity of 2000 lux CCFL) on the simulated IV characteristic of a GaInP PV cell. The fill factor clearly decreases with increased specific contact resistance from $10^{-4}$ $\Omega.cm^2$ to $5.10^{-2}$ $\Omega.cm^2$.

In order to minimise the fractional power loss due to vertical resistance along the metal contact element, the specific contact resistance should preferably be <$10^{-2}$ $\Omega.cm^2$, and more preferably <$10^{-5}$ $\Omega.cm^2$.

In the present invention, the sum of fractional loss due to series resistance and contact shading is therefore reduced compared to conventional metal gridlines design.

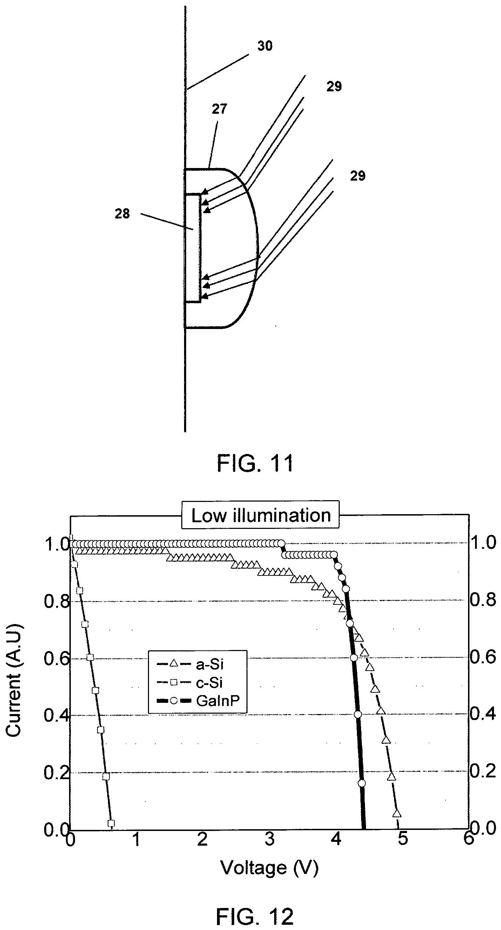

FIG. 12 shows the experimental IV curves of a GaInP PV cell against typical a-Si and c-Si PV cell technologies. The fill factor and thus performance at ultra-low and low light level (e.g <50 $\mu$W.cm$^{-2}$) of the GaInP PV cell according to the present invention is clearly improved compared to a-Si and c-Si PV cells.

Assuming no series resistance, the fill factor of the PV cell is also affected by the shunt resistance according the following equation (Eq. 12):

$$FF_{shunt} = FF_0 \cdot \left(1 - \frac{V_{mp}}{R_{shunt} \cdot J_{mp}}\right) \qquad \text{(Equation 12)}$$

where $FF_0$ is the maximum fill factor of the cell without series and shunt resistance, $R_{shunt}$ is the area-normalised shunt resistance, $J_{mp}$ and $V_{mp}$ the current density and voltage respectively at the maximum powerpoint.

The corresponding fractional power loss due to shunt resistance $P_{shunt}$ is (Eq. 13):

$$P_{shunt} = \frac{V_{mp}}{R_{shunt} \cdot J_{mp}} \qquad \text{(Equation 13)}$$

The term $J_{mp}$ that appears in the previous equations is directly related to the intensity level of the ambient light by the equation (Eq. 14):

$$J_{mp} = k.I_{ambient} \qquad \text{(Equation 14)}$$

where $J_{mp}$ is the current density and voltage at the maximum powerpoint, $I_{ambient}$ is the intensity of the ambient light oncoming on the PV cell, and k is a coefficient of proportionality.

The sum $P_{Total}$ of the power losses due to series, shunt and contact shading should be minimised to optimise the performance of the PV cell under a given range of ambient light level (Eq. 15):

$$P_{Total} = P_{series} + P_{shunt} + P_{shading} \qquad \text{(Equation 15)}$$

In conventional Silicon PV cells, the total fractional power loss $P_{Total}$ due to the series resistance, shunt resistance and contact shading is significant (>20%) at low light level and can become very large (>50%) at ultra-low light level due to the sharp increase of $P_{shunt}$. The dynamic range of ambient light level is therefore limited.

In the present invention, a high band-gap crystalline material, preferably from the group III-V such as (Al)GaInP and the like, is used for the active material of the PV cell. High band-gap crystalline material has low dark saturation current and therefore can achieve a higher shunt resistance than conventional Si material.

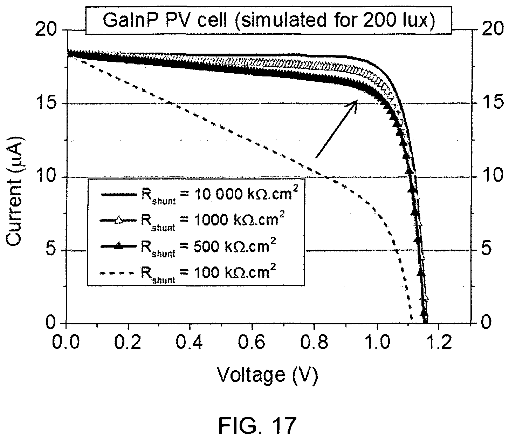

FIG. 17 shows the impact of the shunt resistance on the simulated IV characteristic of a GaInP PV cell, assuming a low light level intensity of 200 lux CCFL. The fill factor clearly increases with increased shunt resistance from $100k\Omega.cm^2$ to $10000k\Omega.cm^2$.

The active material in the present invention is selected and processed such that the area-normalised shunt resistance is preferably $>500k\Omega.cm^2$, and more preferably $>1000k\Omega.cm^2$.

In the present invention, the total fractional power loss $P_{Total}$ due to series, shunt and shading is preferably <20%, more preferably<10%, and yet more preferably<5%.

In order to facilitate the understanding of this invention, reference will now be made to the appended drawings of embodiments of the present invention.

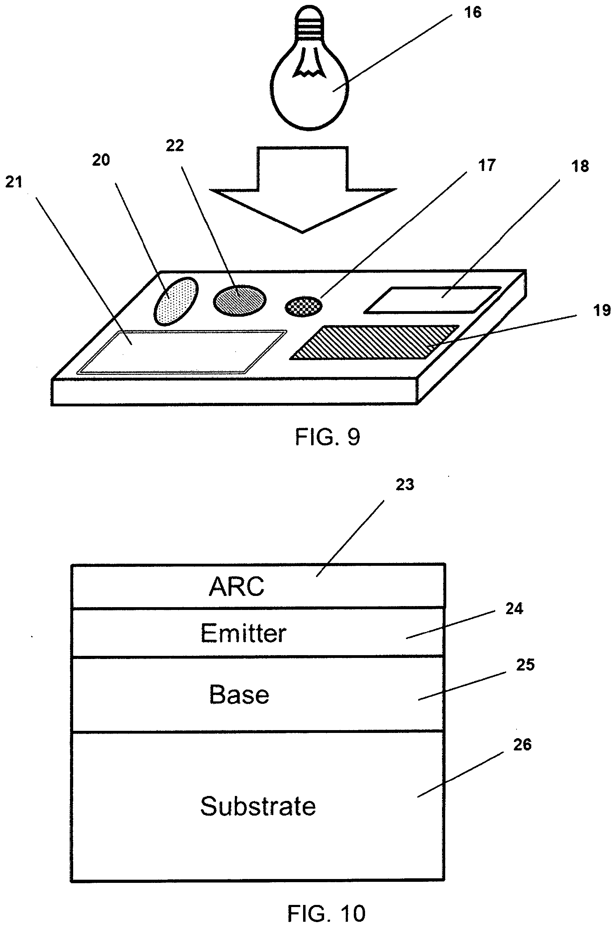

The PVEH device in the present invention may be used to power a wireless sensor as depicted in FIG. 9. The PVEH device 18 is converting electromagnetic energy coming from an ambient light source 16 into electricity. A power management unit 21 is directly connected to the PVEH device 18 and may include a primary and/or secondary battery element. The PVEH device 18 provides power for the sensor 22, the signal processing unit 19 and the signal conditioning 20. An antenna 17 linked with the signal processing unit may be used to transmit data acquired from the sensor 22. In this example, the PVEH device 18 may be used to provide autonomous power to the wireless sensor or only used to extend the lifetime of a battery element. The PVEH device may be wall-mounted as shown in FIG. 11. In this case, an optical lens 27 may be used to redirect the oblique ambient light 29 onto the PV cell 28 that is fixed on a wall 30. The optical element 27 can be made from epoxy and can have different shapes, including but not limited to spherical, cylindrical and Fresnel lenses.

**First embodiment**

An aspect of the invention is a photovoltaic energy harvesting device comprising a single-junction photovoltaic cell. In exemplary embodiments, the photovoltaic cell includes a light converting element made of a wide band-gap III-V active material spectrally matched to an ambient light source, a light receiving side that is free from front metal contact gridlines, and at least one discrete metal contact element placed on the light receiving side that realizes power extraction from the light converting element. The active material of the light converting element is made of (Al)GaInP compounds. The active material of the light converting element is also spectrally matched to ambient light in the form of at least one of an artificial fluorescent light, an artificial solid-state light, natural sunlight, or a combination of artificial light and natural sunlight.

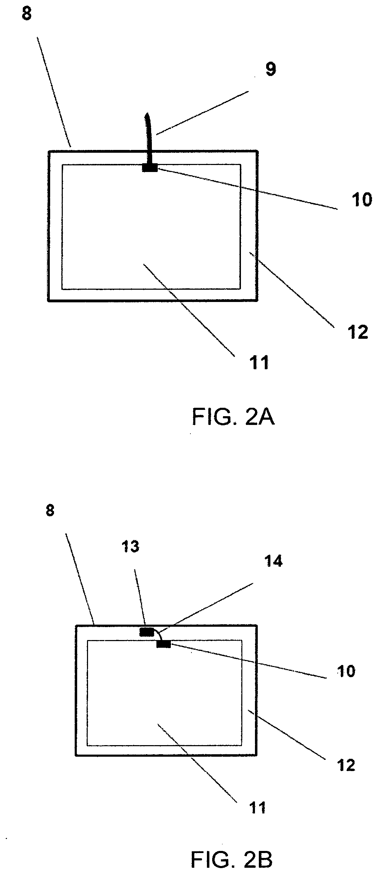

FIG. 2A and FIG. 2B show a constitution of a first embodiment of a high efficient PVEH device 8 from a top view. As used herein, the top view corresponds to the light receiving side. The PVEH device 8 comprises a single PV cell 11, which structure is depicted in the cross-sectional view of FIG. 10, and a single front metal contact element 10 that is placed on one edge of the light receiving side of the PV cell 11. The single metal contact element may be placed on a longer edge of the light receiving side of the PV cell. The PV cell 11 may be mounted on an inactive PVEH area 12.

As shown in FIG. 10, the PV cell is supported by a substrate 26 that can be either rigid or flexible. Examples of rigid substrates include but are not limited to semiconductor substrates such as Gallium Arsenide, Germanium or Silicon substrates. Examples of flexible substrates include but are not limited to polymer and metallic substrates.

The emitter 24 forms a PN junction with the base 25 and is covered by an anti-reflection coating (ARC) 23.

The ARC may comprise a single layer or several dielectric layers and is preferably spectrally-matched with the ambient light source, also increases the short-circuit current density of the PV cell.

For example, the ARC can be made of $Si_3N_4$ with thickness between 40nm and 70nm The emitter **24** and base **25** form a light converting element that constitutes the active material of the PV cell. For example, the emitter can be made of n-type GaInP with thickness between 40nm and 100nm and the base can be made of p-type GaInP with thickness between 300nm and 1000nm. In this example, an AlInP window and AlGaInP back surface field should be preferably used to prevent recombination of carriers (e.g electrons and holes) in the emitter and base layers respectively.

According to the present invention, the active material of the PV cell **11** may include any of the following features:

The active material is a high band-gap crystalline material, preferably from the group III-V such as (Al)GaInP and the like.

In FIG. 7, the experimental external Quantum Efficiency of GaInP PV cell is plotted against typical indoor LED and CCFL irradiance spectra. The band-gap of the active material of the PV cell **11** is preferably selected such that it is spectrally-matched to the ambient light spectrum as shown in FIG. 7.

The ambient light source may be artificial solid-state light such as an Light-Emitting Diode (LED) type light source (e.g. white LED, organic LED, polymer LED).

The ambient light source may also be artificial Fluorescent light such as a Cold Cathode Fluorescent Lamp (CCFL) or Compact Fluorescent Lamps (CFL).

An example of LED and CCFL light spectra is shown in FIG. 7. The ambient light source may also be the natural sunlight or a combination of natural sunlight and artificial light, the artificial light being as described above.

The band-gap of the active material of the PV cell **11** is preferably selected such that the PV cell **11** can provide an open-circuit voltage preferably >0.6 V and even more preferably >1V over a wide range of illumination intensity. As depicted in FIG. 8, the PV cell 11 maintains excellent linear voltage-light intensity dependence down to 1 lux CFL intensity level.

This is in contrast with prior art described in FIG. 1A wherein the PVEH device typically requires several PV cells **7** in series to achieve an open-circuit voltage of >1V.

The active material is selected and processed such that the area-normalised shunt resistance is preferably >500k$\Omega$.cm$^2$, and more preferably >1000k$\Omega$.cm$^2$.

As shown in FIG. 2A and FIG. 2B, the front metal contact element **10** is used to efficiently extract the electrical power from the PV cell **11**. The active material of the PV cell **11** is a high band-gap crystalline material which band-gap is spectrally matched to the ambient light source.

According to the present invention, the front metal contact element **10** may include any of the following features:

The front metal contact element **10** may be of any geometrical shape but should preferably be circular, rectangular, square or point contact pads.

The front metal contact element **10** is substantially small in size and the total area covered by the front metal contact element **10** should preferably represent <5%, more preferably <1% and yet more preferably <0.1% of the total area of the light receiving side of the PV cell **11.**

This is in contrast with prior art described in FIG. 1A, wherein the total shading of PVEH **1** due to metal gridlines **5** and metal bus-bars **4** is typically >>5%.

The optimal size of the front metal contact element **10** in FIG. 2A and FIG. 2B depends on various physical parameters including (but not limited to) PV cell area, the emitter sheet resistance, bulk resistance, specific contact resistance, metal thickness and resistivity. These physical parameters can be obtained by standard metrology techniques such as Transmission Line Measurement (TLM).

In order to reduce the area of the front metal contact element to within the above specifications, the emitter sheet resistance should preferably be <1000 $\Omega/\square$, and more preferably <100 $\Omega/\square$.

In order to reduce the area of the front metal contact element to within the above specifications, the specific contact resistance should preferably be <$10^{-2}$ $\Omega$.cm$^2$, <$10^{-4}$ $\Omega$.cm$^2$ and more preferably <$10^{-5}$ $\Omega$.cm$^2$.

In the present invention, the total fractional power loss $P_{Total}$ due to series resistance, shunt resistance and contact shading is preferably <20%, more preferably<10%, and yet more preferably<5%.

The optimal size of the front metal contact element **10** also depends on the dynamic range of PVEH operation. The PVEH **8** in the present invention achieves low total fractional power loss over a wide dynamic range from ultra-low light, low to at least moderate light levels. The PVEH **8** in the present invention also preferably achieves low total fractional power loss at high light level.

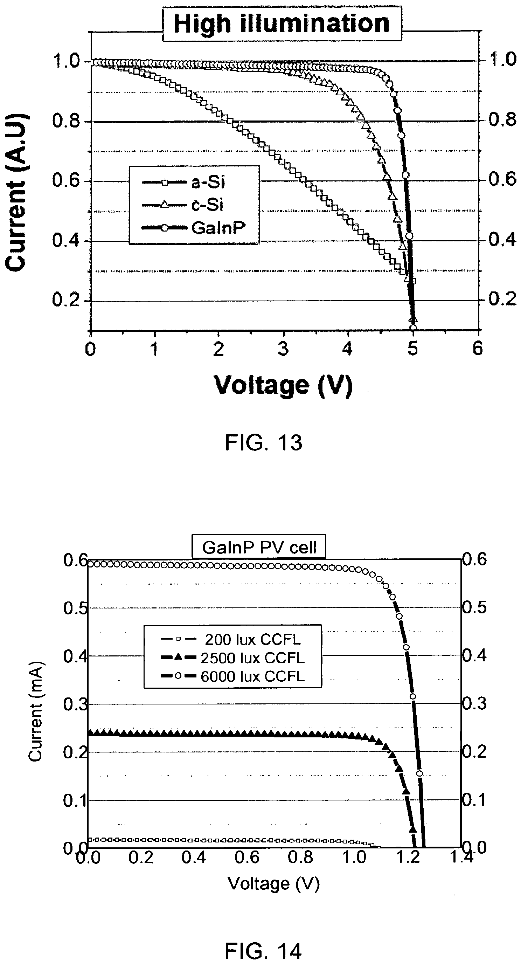

FIG. 14 shows the experimental IV curves of a GaInP PV cell for 200 lux, 2500 lux, and 6000 lux CCFL light levels. The fill factor and open-circuit voltage of the GaInP PV cell according to the present invention is above 80% and 1.1 V respectively for all light levels, which shows that a low total fractional power loss can be achieved over a wide range of light levels.

FIG. 12 shows the experimental IV curves of a GaInP PVEH device against typical a-Si and c-Si PV cell technologies under low illumination (e.g <50 $\mu$W.cm$^{-2}$). The fill factor and thus performance at ultra-low and low light level of the GaInP PVEH device according to the present invention is improved compared to a-Si and c-Si PVEH devices.

FIG. 13 shows the experimental IV curves of a GaInP PVEH device against typical a-Si and c-Si PV cell technologies under high illumination (e.g >2500 $\mu$W.cm$^{-2}$). The fill factor and thus performance at high light level of the GaInP PVEH device according to the present invention is also improved compared to a-Si and c-Si PVEH devices.

The front metal contact element **10** may be directly connected to an electrical lead **9** (FIG. 2A). The electrical lead **9** may be a metal wire or a metal tab, and methods of attachment to the front metal contact element **10** include bonding, soldering and the like.

The front metal contact element **10** may also be connected to additional external metal pads **13** located outside the perimeter of the PV cell **11** (FIG. 2B). Methods of indirect connection to the front metal contact element **10** include wire bonding with metal wire **14.** Indirect connection methods are similar to prior art described in FIG. 1A whereby power is extracted through external metal pads **3** connected by metal wire **6** to busbar **4.**

In both FIG. 2A and FIG. 2B, inactive PVEH area **12** should be kept as small as possible. The direct connection to an electrical lead (FIG. 2A) is a preferred option in this embodiment because the inactive PVEH area **12** can be reduced to nothing.

Indirect connection will be represented as the default connection method in the following figures. It should be understood that this is not a restriction and that direct connection may be also be used in any of the embodiments described below even if not mentioned subsequently in the description of figures.

The front metal contact element **10** is preferably patterned using a non-lithographic method such as screen-printing or metal fusion, but not necessarily.

The front metal contact element **10** may be based on AuGeNi or In-based alloys if the contact layer of the PV cell **11** is n-type GaAs.

The front metal contact element **10** may be based solely on Indium solder if the contact layer of the PV cell **11** is n-type GaAs.

## Second embodiment

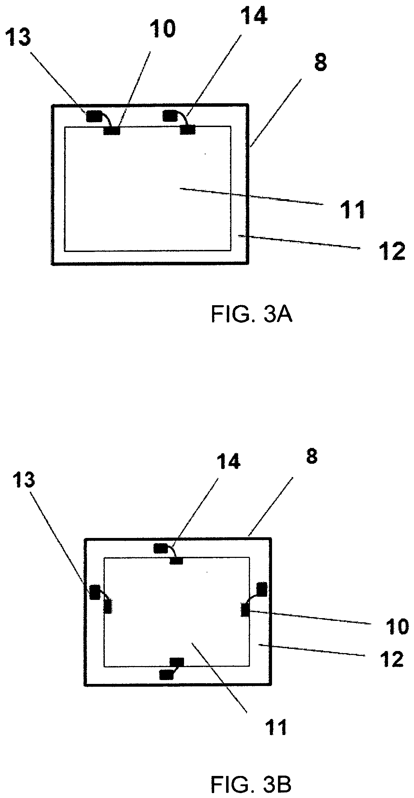

In a second embodiment, as described in FIG. 3A-3B-3C, the PV cell **11** of the PVEH device **8** comprises a plurality of front metal contact elements **10.**

The PV cell **11** and the front metal contact elements **10** have the same attributes as in the first embodiment.

The front contact elements **10** may be configured on the same and preferably longer edge of the PV cell **11** (FIG. 3A).

The front metal contact elements **10** may also be configured on different edges of the PV cell **11** (FIG. 3B).

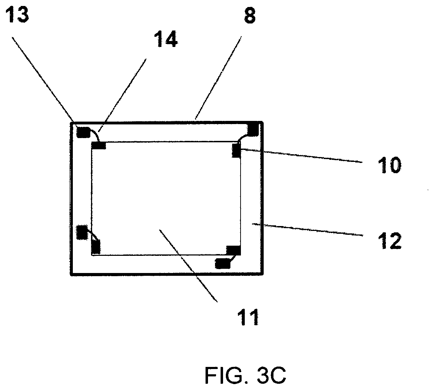

The front metal contact elements **10** may finally be configured at each corner of the PV cell **11** (FIG. 3C).

All these configurations of front metal contact elements **10** reduce the series resistance loss as compared to the first embodiment, but increase the shading loss due to the front metal contact elements **10.**

The optimal configuration of front metal contact elements **10** depends on various physical parameters including (but not limited to) PV cell area, PV cell sheet resistance, bulk resistance, specific contact resistance, metal thickness and resistivity. These physical parameters can be obtained by standard metrology techniques such as Transmission Line Measurement (TLM).

In order to reduce the area of the front metal contact element to within the above specifications, the emitter sheet resistance should preferably be <1000 $\Omega/\square$, and more preferably <100 $\Omega/\square$.

In order to reduce the area of the front metal contact element to within the above specifications, the specific contact resistance should preferably be <10$^{-2}$ $\Omega$.cm$^2$, <10$^{-4}$ $\Omega$.cm$^2$ and more preferably <10$^{-5}$ $\Omega$.cm$^2$.

In the present invention, the total fractional power loss $P_{Total}$ due to series resistance, shunt resistance and contact shading is preferably <20%, more preferably<10%, and yet more preferably<5%.

## Third embodiment

In a third embodiment, the front metal contact element may be configured as an elongated metal contact element **15,** which is elongated and covers at least one edge of the PV cell **11.** Two main contact configurations are described:

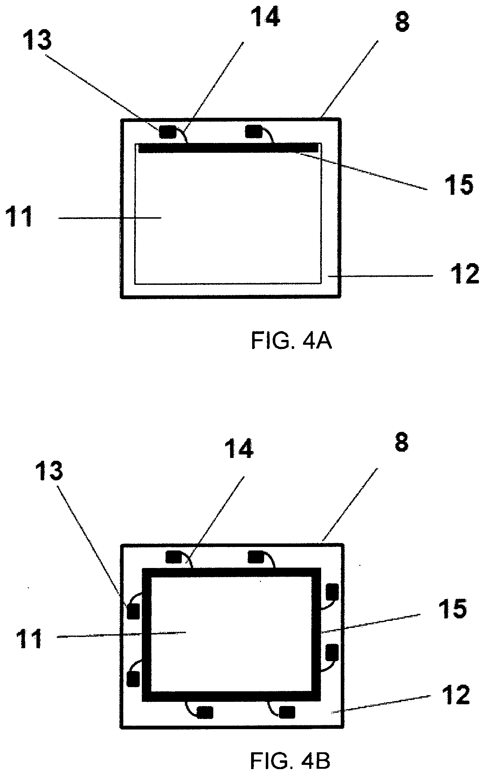

The front metal contact element **15** may cover only one edge of the PV cell 11 (FIG. 4A)

Front metal contact element **15** may cover the whole perimeter of the PV cell **11** (FIG. 4B).

Both configurations of elongated front metal contact elements **15** reduce further the series resistance loss as compared to the second embodiment, but increase the shading loss as compared to the non-elongated front metal contact elements **10**.

The optimal configuration of elongated front metal contact elements **15** depends on various physical parameters including (but not limited to) PV cell area, PV cell sheet resistance, bulk resistance, specific contact resistance, metal thickness and resistivity. These physical parameters can be obtained by standard metrology techniques such as Transmission Line Measurement (TLM).

In order to reduce the area of the front metal contact element to within the above specifications, the emitter sheet resistance should preferably be <1000 $\Omega/\square$, and more preferably <100 $\Omega/\square$.

In order to reduce the area of the front metal contact element to within the above specifications, the specific contact resistance should preferably be <$10^{-2}$ $\Omega.cm^2$, <$10^{-4}$ $\Omega.cm^2$ and more preferably <$10^{-5}$ $\Omega.cm^2$.

In the present invention, the total fractional power loss $P_{Total}$ due to series resistance, shunt resistance and contact shading is preferably <20%, more preferably<10%, and yet more preferably<5%.

**Fourth embodiment**

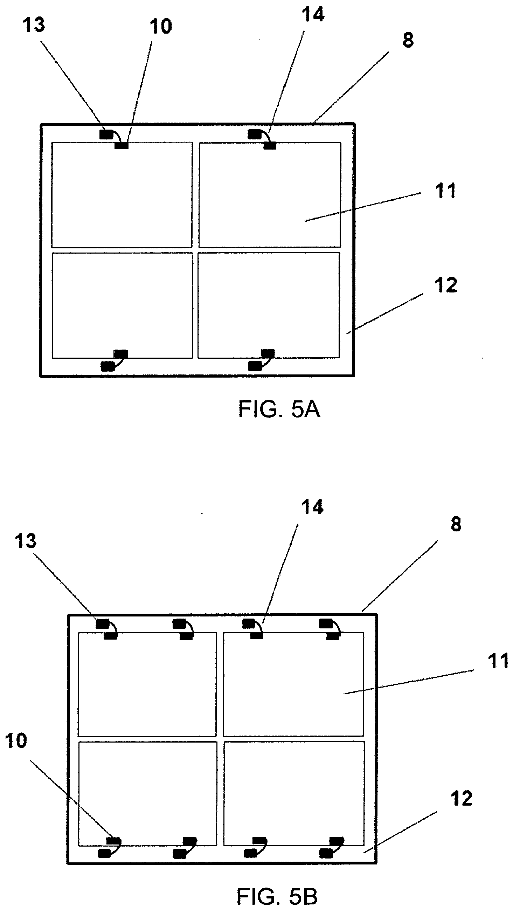

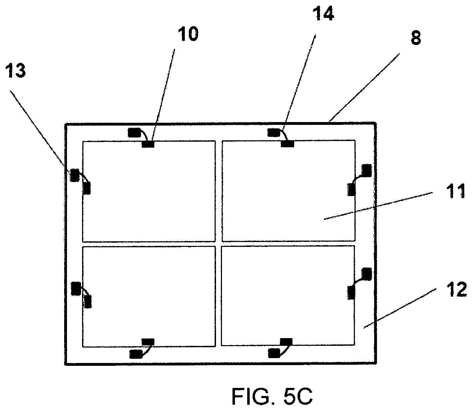

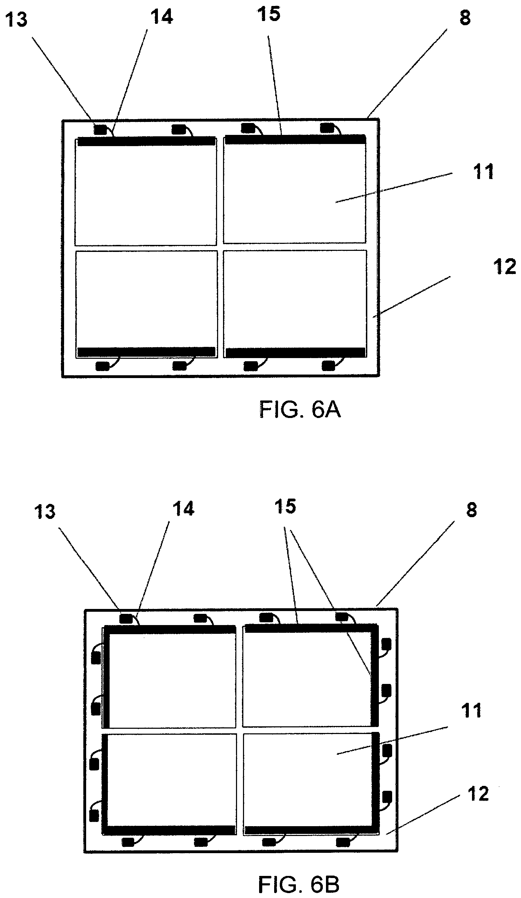

In a fourth embodiment, as described in FIG. 5 and FIG. 6, the PVEH device **8** includes a plurality of PV cells **11** connected in series to achieve a higher open-circuit voltage. Each PV cell may be made of a III-V material. Four PV cells **11** connected in series are shown in the description thereafter, and it should be noted this configuration is not a limitation and is only chosen for illustration purposes. A person skilled in the art would understand how to adapt the described exemplary embodiments to a different number of PV cells and to a different configuration of series or parallel connection.

One example of open-circuit voltage range achievable by the PVEH **8** in the present invention is 4V and above.

This is in contrast with prior art described in FIG. 1A wherein the PVEH device typically requires eight PV cells **7** in series to achieve the same range of open-circuit voltage (e.g 4V and above).

As described in FIG. 5A, the PVEH device **8** may comprise four PV cells **11** connected in series wherein a single front metal contact element **10** is placed on the light receiving side of each PV cell **11**. The front metal contact element **10** is preferably placed at the middle of the outer longer edge of each PV cell **11** to minimise shading loss in the central and visible region of the PVEH device **8**.

As described in FIG. 5B, the PVEH device **8** may also comprise four PV cells **11** connected in series wherein multiple front metal contact elements **10** are placed on the same edge on the light receiving side of the PV cell **11**. The front metal contact element **10** is preferably placed at the outer longer edge of each PV cell **11** to minimise shading loss in the central and visible region of the PVEH device **8**.

As described in FIG. 5C, the PVEH device **8** may also comprise four PV cells **11** connected in series wherein multiple front metal contact elements **10** are placed on different edges on the light receiving side of each PV cell **11**. The front metal contact elements **10** are preferably placed at the outer edges of each PV cell **11** to minimise shading loss in the central and visible region of the PVEH device **8**.

As shown in FIG. 6A, the PVEH device **8** may also comprise four PV cells **11** connected in series wherein a single elongated front metal contact element **15** is covering one edge on the light receiving side of each PV cell **11**. The elongated front metal contact element **15** is preferably covering the outer longer edge of each PV cell **11** to minimise shading loss in the central and visible region of the PVEH device **8**.

As shown in FIG. 6B, the PVEH device **8** may also comprise four PV cells **11** connected in series wherein multiple elongated front metal contact elements **15** each are covering one edge on the light receiving side of each PV cell **11**. The front metal contact elements **15** are preferably covering the outer edges of each PV cell **11** to minimise shading loss in the central and visible region of the PVEH device **8**.

As in previous embodiments, in the embodiments of FIGs. 5A-C and 6A-B, there may be an indirect connection to the front metal contact elements **10** or **15** by wire bonding with a metal wire **14**.

The optimal configuration of front metal contact elements **10** or **15** depends on various physical parameters including (but not limited to) PV cell area, PV cell sheet resistance, bulk resistance, specific contact resistance, metal thickness and resistivity. These physical parameters can be obtained by standard metrology techniques such as Transmission Line Measurement (TLM).

In order to reduce the area of the front metal contact element to within the above specifications, the emitter sheet resistance should preferably be <1000 $\Omega/\square$, and more preferably <100 $\Omega/\square$.

In order to reduce the area of the front metal contact element to within the above specifications, the specific contact resistance should preferably be <$10^{-2}$ $\Omega.cm^2$, <$10^{-4}$ $\Omega.cm^2$ and more preferably <$10^{-5}$ $\Omega.cm^2$.

In the present invention, the total fractional power loss $P_{Total}$ due to series resistance, shunt resistance and contact shading is preferably <20%, more preferably<10%, and yet more preferably<5%.

In accordance with this description, an aspect of the invention is a photovoltaic energy harvesting device. In exemplary embodiments, the photovoltaic energy harvesting device includes a single-junction photovoltaic cell. The photovoltaic cell comprises includes a light converting element made of a wide band-gap III-V active material spectrally matched to an ambient light source, a light receiving side that is free from front metal contact gridlines, and at least one discrete metal contact element placed on the light receiving side that realizes power extraction from the light converting element.

In the present invention, the active material of the light converting element is made of (Al)GaInP compounds.

In an exemplary embodiment of the photovoltaic energy harvesting device, the active material of the light converting element is spectrally matched to at least one of an artificial fluorescent light, an artificial solid-state light, natural sunlight, or a combination of artificial light and natural sunlight.

In an exemplary embodiment of the photovoltaic energy harvesting device, the light receiving side includes only one metal contact element located on a longer edge of the photovoltaic cell.

In an exemplary embodiment of the photovoltaic energy harvesting device, the light receiving side includes a plurality of metal contact elements located on a same edge of the photovoltaic cell.

In an exemplary embodiment of the photovoltaic energy harvesting device, the light receiving side of the photovoltaic cell includes a plurality of metal contact elements located on different edges of the photovoltaic cell.

In an exemplary embodiment of the photovoltaic energy harvesting device, the at least one metal contact element is one of a point contact pad, a circular contact pad, or a rectangular contact pad. In the present invention, a total area covered by the at least one metal contact element is less than 5% of a total area of the light receiving side of the photovoltaic cell.

In an exemplary embodiment of the photovoltaic energy harvesting device, the at least one metal contact element is patterned using one of a low resolution photo-lithography method, a screen-printing method, or a soldering method.

In an exemplary embodiment of the photovoltaic energy harvesting device, the at least one metal contact element is made of at least one of AuGeNi alloy or Indium. In an exemplary embodiment of the photovoltaic energy harvesting device, the photovoltaic energy harvesting device comprises a plurality of photovoltaic cells made of III-V material inter-connected in series to achieve a higher open-circuit voltage.

In the present invention, an area-normalised shunt resistance is greater than $500k\Omega.cm^2$.

In an exemplary embodiment of the photovoltaic energy harvesting device, a specific contact resistance of the at least one metal contact element is less than $10^{-2}\ \Omega.cm^2$. In an exemplary embodiment of the photovoltaic energy harvesting device, a total fractional power loss due to series resistance, shunt resistance and contact shading is less than 20%.

In an exemplary embodiment of the photovoltaic energy harvesting device, a total fractional power loss due to series resistance, shunt resistance and contact shading under ultra-low light level is less than 20%.

In an exemplary embodiment of the photovoltaic energy harvesting device, a total fractional power loss due to series resistance, shunt resistance and contact shading under low light level is less than 20%.

In an exemplary embodiment of the photovoltaic energy harvesting device, a total fractional power loss due to series resistance, shunt resistance and contact shading under moderate light level is less than 20%.

In an exemplary embodiment of the photovoltaic energy harvesting device, a total fractional power loss due to series resistance, shunt resistance and contact shading under high light level is less than 20%. In the present invention, the photovoltaic cell includes an anti-reflection coating that is spectrally matched with the ambient light source.

In an exemplary embodiment of the photovoltaic energy harvesting device, the PV cell includes a spherical optical lens element or a Fresnel optical lens element. According to an aspect of the invention, the PV active material is made of (Al)GaInP III-V semi-conductor compounds.

The use of a PV active material spectrally-matched with the ambient light source increases the short-circuit current density of the PV cells, thereby improving the performance of the PVEH device.

According to another aspect of the invention, the ambient light source is artificial fluorescent type light such as Cold Cathode Fluorescent Lamp (CCFL) or Compact Fluorescent lamp (CFL).

According to still another aspect of the invention, the ambient light source is artificial solid-state light such as Light-Emitting Diode (LED) type light (white LED, organic LED, polymer LED)

According to yet another aspect of the invention, the ambient light source is the natural sunlight or a combination of natural sunlight and artificial light.

The use of a single layer or bi-layer Anti-Reflection Coating (ARC) that is spectrally-matched with the ambient light source, also increases the short-circuit current density of the PV cell.

According to another aspect of the invention, the PVEH module comprises several PV cells inter-connected in series to achieve a higher open-circuit voltage.

The electrical power extraction is solely provided by one or several discrete front metal contact elements located at the perimeter of the PV cells.

The low area covered by the discrete front metal contact elements on the PV cells reduces the contact shading compared with conventional front metal gridlines contact designs.

According to another aspect of the invention, the total area covered by the front metal contact elements on the PV cells is less than 5%.

According to another aspect, the total area covered by the front metal contact elements on the PV cells is less than 1%.

According to another aspect, the total area covered by the front metal contact elements on the PV cells is less than 0.1%.

The combination of discrete front metal contact elements and high band crystalline active material reduces the total fractional power loss compared with conventional front metal gridlines contact designs.

According to another aspect of the invention, the front metal contact elements on the PV cells provide a total fractional power loss due to series resistance, shunt resistance and contact shading of less than 20%.

According to another aspect of the invention, the front metal contact elements on the PV cells provide a total fractional power loss due to series resistance, shunt resistance and contact shading of less than 10%.

According to another aspect, the front metal contact elements on the PV cells provide a total fractional power loss due to series resistance, shunt resistance and contact shading of less than 5%.

According to another aspect, the front metal contact elements on the PV cells provide a total fractional power loss due to series resistance, shunt resistance and contact shading of less than 1%.

In accordance with another aspect, the front metal contact elements are point contact pads.

In accordance with another aspect, the front metal contact elements are circular contact pads.

In accordance with another aspect, the front metal contact elements are rectangular contact pads.

In accordance with another aspect, the front metal contact elements are elongated bus-bars.

According to another aspect, the electrical power extraction from the PV cells is realised through electrical wires bonded or soldered to the front metal contact elements on the PV cells.

According to another aspect, the electrical power extraction from the PV cells is realised through electrical tabs bonded to the front metal contact elements on the PV cells.

According to yet another aspect, the electrical power extraction and/or interconnection between PV cells is realised solely through a single front contact element on the PV cells. The positioning of the front metal contact elements at the perimeter only of the light receiving side of the PV cells improves the colour uniformity and overall aesthetics of the PVEH device.

According to another aspect, the electrical power extraction and/or interconnection is realised through additional contact pads placed outside the PV cells area, each of these external pads being electrically connected to the front metal contact elements of the PV cells.

According to still another aspect, the front metal contact elements are placed on a single and preferably longer edge of the PV cells.

According to still another aspect, the front metal contact elements are placed on several edges of the PV cells.

According to still another aspect, the front metal contact elements are placed on each corner of the PV cells.

According to yet another aspect, the front metal contact elements are placed along the whole perimeter of the light receiving side of the PV cells.

The discrete front metal contact elements on the PV cells can be fabricated using processing techniques that are more cost effective than standard high resolution photo-lithography method.

According to another aspect, the front metal contact elements are made by a low resolution photo-lithographic method.

According to another aspect, the front metal contact elements are made by a non photo-lithographic method, e.g. screen printing, shadow mask deposition, soldering, electro-plating or inkjet printing.

According to another aspect, the metal of the front metal contact elements is made of AuGeNi alloys.

According to another aspect, the metal of the front metal contact elements is made of Indium solder.

**INDUSTRIAL APPLICABILITY**

The PVEH device according to the present invention may be used as a renewable power source for low power sensors and devices.

**Claims**

1. A photovoltaic energy harvesting device (8) comprising a single-junction photovoltaic cell (11), wherein the photovoltaic cell comprises:

a light converting element (24, 25) made of (Al)GaInP III-V active material spectrally matched to an ambient light source, and said active material has a direct band-gap in a range of 1.12 eV to 2.0 eV,

an anti-reflection coating (23) that is spectrally matched with the ambient light source, and wherein

the photovoltaic cell (11) has a light receiving side (12) that is free from front metal contact gridlines; and at least one discrete metal contact element (10) placed on the light receiving side that realizes power extraction from the light converting element, and wherein

a total area covered by the at least one metal contact element is less than 5% of a total area of the light receiving side of the photovoltaic cell (11), and an area-normalised shunt resistance of said photovoltaic cell is not less than $500k\Omega.cm^2$

2. The photovoltaic energy harvesting device (8) of claim 1, wherein the active material of the light converting element (24, 25) is spectrally matched to at least one of an artificial fluorescent light, an artificial solid-state light, natural sunlight, or a combination of artificial light and natural sunlight.

3. The photovoltaic energy harvesting device (8) of any of claims 1 or 2, wherein the light receiving side (12) includes only one metal contact element (10) located on a longer edge of the photovoltaic cell (11).

4. The photovoltaic energy harvesting device (8) of any of claims 1 or 2, wherein the light receiving side (12) includes a plurality of metal contact elements located on a same edge of the photovoltaic cell (11).

5. The photovoltaic energy harvesting device (8) of any of claims 1 or 2, wherein the light receiving side (12) of the photovoltaic cell includes a plurality of metal contact elements (10) located on different edges of the photovoltaic cell (11).

6. The photovoltaic energy harvesting device (8) of any of claims 1 to 5, wherein the at least one metal contact element (10) is one of a point contact pad, a circular contact pad, or a rectangular contact pad.

7. The photovoltaic energy harvesting device (8) of any of claims 1 to 6, wherein the at least one metal contact element (10) is patterned as a result of using one of a low resolution photo-lithography method, a screen-printing method, or a soldering method.

8. The photovoltaic energy harvesting device (8) of any of claims 1 to 7, wherein the photovoltaic energy harvesting device comprises a plurality of photovoltaic cells (11) made of III-V material inter-connected in series to achieve a higher open-circuit voltage.

9. The photovoltaic energy harvesting device (8) of any of claims 1 to 8, wherein a specific contact resistance of the at least one metal contact element is less than $10^{-2}\ \Omega.cm^2$.

10. The photovoltaic energy harvesting device (8) of any of claims 1 to 9, wherein a total fractional power loss due to series resistance, shunt resistance and contact shading under low light level is less than 20%, wherein low light level refers to a light intensity level between 25 and $100\mu W/cm^2$.

11. The photovoltaic energy harvesting (8) device of any of claims 1 to 10, wherein the photovoltaic cell includes a spherical optical lens element or a Fresnel optical lens element (27).

12. The photovoltaic energy harvesting device (8) of any of claims 1 to 11, wherein said active material comprises at least an emitter (24) made of (Al)GaInP and a base material (25) made of (Al)GaInP, a sheet resistance of said emitter being not more than $1000\ \Omega/\square$.

**Patentansprüche**

1. Fotovoltaische Energiegewinnungsvorrichtung (8), aufweisend eine Single-Junction-Fotovoltaikzelle (11), wobei die Fotovoltaikzelle aufweist:

ein lichtumwandelndes Element (24, 25), das aus einem (Al)GaInP-III-V-Aktivmaterial besteht, das auf eine Umgebungslichtquelle spektral abgestimmt ist, und das Aktivmaterial eine direkte Bandlücke in einem Bereich von 1,12 eV bis 2,0 eV aufweist,

eine Antireflexionsbeschichtung (23), die mit der Umgebungslichtquelle spektral abgestimmt ist, und wobei die Fotovoltaikzelle (11) eine Lichtempfangsseite (12), die frei von vorderen Metallkontaktgitterlinien ist, und zumindest ein auf der Lichtempfangsseite platziertes diskretes Metallkontaktelement (10) aufweist, das eine Leistungsextraktion vom lichtumwandelnden Element realisiert, und wobei eine Gesamtfläche, die von dem zumindest einen Metallkontaktelement bedeckt ist, geringer als 5 % einer Gesamtfläche der Lichtempfangsseite der Fotovoltaikzelle (11) ist und ein flächennormierter Nebenschlusswiderstand der Fotovoltaikzelle nicht geringer als 500 k$\Omega$.cm$^2$ ist.

2. Fotovoltaische Energiegewinnungsvorrichtung (8) nach Anspruch 1, wobei das Aktivmaterial des lichtumwandelnden Elements (24, 25) auf zumindest eines eines künstlichen Fluoreszenzlichts, eines künstlichen Festkörperlichts, eines natürlichen Sonnenlichts oder einer Kombination von künstlichem Licht und natürlichem Sonnenlicht spektral abgestimmt ist.

3. Fotovoltaische Energiegewinnungsvorrichtung (8) nach einem der Ansprüche 1 oder 2, wobei die Lichtempfangsseite (12) nur ein an einer längeren Kante der Fotovoltaikzelle (11) gelegenes Metallkontaktelement (10) enthält.

4. Fotovoltaische Energiegewinnungsvorrichtung (8) nach einem der Ansprüche 1 oder 2, wobei die Lichtempfangsseite (12) eine Vielzahl von an einer gleichen Kante der Fotovoltaikzelle (11) gelegenen Metallkontaktelementen enthält.

5. Fotovoltaische Energiegewinnungsvorrichtung (8) nach einem der Ansprüche 1 oder 2, wobei die Lichtempfangsseite (12) der Fotovoltaikzelle eine Vielzahl von an verschiedenen Kanten der Fotovoltaikzelle (11) gelegenen Metallkontaktelementen (10) enthält.

6. Fotovoltaische Energiegewinnungsvorrichtung (8) nach einem der Ansprüche 1 bis 5, wobei das zumindest eine Metallkontaktelement (10) eines eines punktförmigen Kontakt-Pads, eines kreisförmigen Kontakt-Pads oder eines rechteckigen Kontakt-Pads ist.

7. Fotovoltaische Energiegewinnungsvorrichtung (8) nach einem der Ansprüche 1 bis 6, wobei das zumindest eine Metallkontaktelement (10) als Ergebnis der Verwendung eines Fotolithografieverfahrens mit geringer Auflösung, eines Siebdruckverfahrens oder eines Lötverfahrens strukturiert ist.

8. Fotovoltaische Energiegewinnungsvorrichtung (8) nach einem der Ansprüche 1 bis 7, wobei die fotovoltaische Energiegewinnungsvorrichtung eine Vielzahl von aus einem III-V-Material bestehenden Fotovoltaikzellen (11) aufweist, die in Reihe miteinander verbunden sind, um eine höhere Ruhespannung zu erzielen.

9. Fotovoltaische Energiegewinnungsvorrichtung (8) nach einem der Ansprüche 1 bis 8, wobei ein spezifischer Kontaktwiderstand des zumindest einen Metallkontaktelements geringer als $\Omega$.cm$^2$ ist.

10. Fotovoltaische Energiegewinnungsvorrichtung (8) nach einem der Ansprüche 1 bis 9, wobei ein gesamter anteiliger Leistungsverlust aufgrund eines Reihenwiderstands, eines Nebenschlusswiderstands und einer Kontaktabschattung unter einem niedrigen Lichtpegel geringer als 20 % ist, wobei sich ein niedriger Lichtpegel auf einen Lichtintensitätspegel zwischen 25 und 100 $\mu$W/cm$^2$ bezieht.

11. Fotovoltaische Energiegewinnungsvorrichtung (8) nach einem der Ansprüche 1 bis 10, wobei die Fotovoltaikzelle ein Element einer sphärischen optischen Linse oder ein Element (27) einer optischen Fresnel-Linse enthält.

12. Fotovoltaische Energiegewinnungsvorrichtung (8) nach einem der Ansprüche 1 bis 11, wobei das Aktivmaterial zumindest einen aus (Al)GaInP bestehenden Emitter (24) und ein aus (Al)GaInP bestehendes Basismaterial (25) aufweist, wobei ein Flächenwiderstand des Emitters nicht mehr als 1000 $\Omega$/$\square$ beträgt.

**Revendications**

1. Dispositif de récupération d'énergie photovoltaïque (8) comprenant une cellule photovoltaïque à jonction unique (11), dans lequel la cellule photovoltaïque comprend :

un élément convertisseur de lumière (24, 25) en matériau actif (Al)GaInP III-V accordé spectralement à une source de lumière ambiante, et ledit matériau actif a un intervalle de bande direct dans une plage de 1,12 eV à 2,0 eV,
un revêtement antireflet (23) qui est accordé spectralement à la source de lumière ambiante, et dans lequel la cellule photovoltaïque (11) a un côté récepteur de lumière (12) qui est dépourvu de lignes de grille de contact en métal avant ; et au moins un élément de contact en métal discret (10) placé sur le côté récepteur de lumière qui réalise une extraction de puissance depuis l'élément convertisseur de lumière, et dans lequel une superficie totale couverte par le au moins un élément de contact en métal est inférieure à 5 % d'une superficie totale du côté récepteur de lumière de la cellule photovoltaïque (11), et une résistance en parallèle à superficie normalisée de ladite cellule photovoltaïque n'est pas inférieure à 500 kΩ.cm$^2$.

2. Dispositif de récupération d'énergie photovoltaïque (8) de la revendication 1, dans lequel le matériau actif de l'élément convertisseur de lumière (24, 25) est accordé spectralement à l'une au moins d'une lumière fluorescente artificielle, d'une lumière à l'état solide artificielle, d'une lumière solaire naturelle ou d'une combinaison de lumière artificielle et de lumière solaire.

3. Dispositif de récupération d'énergie photovoltaïque (8) de l'une quelconque des revendications 1 ou 2, dans lequel le côté récepteur de lumière (12) inclut seulement un élément de contact en métal (10) situé sur un bord plus long de la cellule photovoltaïque (11).

4. Dispositif de récupération d'énergie photovoltaïque (8) de l'une quelconque des revendications 1 ou 2, dans lequel le côté récepteur de lumière (12) inclut une pluralité d'éléments de contact en métal situés sur un même bord de la cellule photovoltaïque (11).

5. Dispositif de récupération d'énergie photovoltaïque (8) de l'une quelconque des revendications 1 ou 2, dans lequel le côté récepteur de lumière (12) de la cellule photovoltaïque inclut une pluralité d'éléments de contact en métal (10) situés sur des bords différents de la cellule photovoltaïque (11).

6. Dispositif de récupération d'énergie photovoltaïque (8) de l'une quelconque des revendications 1 à 5, dans lequel le au moins un élément de contact en métal (10) est l'une d'une plage de contact ponctuelle, d'une plage de contact circulaire ou d'un plage de contact rectangulaire.

7. Dispositif de récupération d'énergie photovoltaïque (8) de l'une quelconque des revendications 1 à 6, dans lequel le au moins un élément de contact en métal (10) est à motif à la suite de l'utilisation de l'un d'un procédé de photolithographie à faible résolution, d'un procédé de sérigraphie ou d'un procédé de brasage.

8. Dispositif de récupération d'énergie photovoltaïque (8) de l'une quelconque des revendications 1 à 7, dans lequel le dispositif de récupération d'énergie photovoltaïque comprend une pluralité de cellules photovoltaïques (11) en un matériau III-V interconnectées en série pour obtenir une tension en circuit ouvert plus élevée.

9. Dispositif de récupération d'énergie photovoltaïque (8) de l'une quelconque des revendications 1 à 8, dans lequel une résistance de contact spécifique du au moins un élément de contact en métal (10) est inférieure à Ω.cm$^2$.

10. Dispositif de récupération d'énergie photovoltaïque (8) de l'une quelconque des revendications 1 à 9, dans lequel un perte de puissance fractionnaire totale due à une résistance série, à une résistance en parallèle et à une tache de contact sous un niveau de lumière bas est inférieure à 20 %, dans lequel niveau de lumière bas se réfère à un niveau d'intensité de lumière entre 25 et 100μW/cm$^2$.

11. Dispositif de récupération d'énergie photovoltaïque (8) de l'une quelconque des revendications 1 à 10, dans lequel la cellule photovoltaïque inclut un élément de lentille optique sphérique ou un élément de lentille optique de Fresnel (27).

12. Dispositif de récupération d'énergie photovoltaïque (8) de l'une quelconque des revendications 1 à 11, dans lequel ledit matériau actif comprend au moins un émetteur (24) en (Al)GaInP et un matériau de base (25) en (Al)GaInP, une résistance de couche dudit émetteur n'étant pas supérieure à 1000 Ω/□.

FIG. 1A

FIG. 1B

**FIG. 2A**

**FIG. 2B**

FIG. 3A

FIG. 3B

FIG. 3C

FIG. 4A

FIG. 4B

FIG. 5A

FIG. 5B

FIG. 5C

FIG. 6A

FIG. 6B

FIG. 7

FIG. 8

FIG. 9

| ARC |
| :---: |
| Emitter |
| Base |
| Substrate |

FIG. 10

FIG. 11

FIG. 12

FIG. 13

FIG. 14

FIG. 15

FIG. 16

FIG. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20110186115 A1

- US 20090250101 A1

### Non-patent literature cited in the description

- **E. YABLONOVITCH.** The Opto-Electronic Physics that Broke the Efficiency Limit in Solar Cells. *PVSC,* 2012
- **FREUNEK.** Maximum Efficiencies of Indoor Photovoltaic Devices. *IEEE Journal of Photovoltaics,* 2013

- **P. DAI et al.** The investigation of GaInP solar cell grown by all-solid MBE. *Journal of Crystal Growth,* 01 September 2013, vol. 378, ISSN 0022-0248, 604-606, http://dx.doi.org/10.1016/j.jcrys-gro.2012.12.038
- **J. F. GEISZ et al.** Enhanced external radiative efficiency for 20.8% efficient single-junction GaInP solar cells. *Applied Physics Letters,* 01 January 2013, vol. 103, ISSN 0003-6951, 041118